Europäisches Patentamt

European Patent Office

Office européen des brevets

(19)

(11) Publication number: **0 398 357**
**A2**

(12) # EUROPEAN PATENT APPLICATION

(21) Application number: 90109468.0

(51) Int. Cl.5: **G11C 29/00, G06F 11/26**

(22) Date of filing: **18.05.90**

(30) Priority: **19.05.89 JP 125869/89**

(43) Date of publication of application:
**22.11.90 Bulletin 90/47**

(84) Designated Contracting States:
**DE FR GB**

(71) Applicant: **Kabushiki Kaisha Toshiba**
**72, Horikawa-cho Saiwai-ku**
**Kawasaki-shi(JP)**

Applicant: **TOSHIBA MICRO-ELECTRONICS**
**CORPORATION**
**25-1, Ekimaehoncho**
**Kawasaki-ku Kawasaki-shi(JP)**

(72) Inventor: **Sashihara, Fumio, c/o Intellectual**
**Property Div.**
**K.K. Toshiba, 1-1 Shibaura 1-chome**
**Minato-ku, Tokyo 105(JP)**
Inventor: **Takahashi, Tomomichi, c/o**
**Intellectual Property Di**
**K.K. Toshiba, 1-1 Shibaura 1-chome**
**Minato-ku, Tokyo 105(JP)**

(74) Representative: **Lehn, Werner, Dipl.-Ing. et al**
**Hoffmann, Eitle & Partner Patentanwälte**
**Arabellastrasse 4**
**D-8000 München 81(DE)**

(54) Test circuit in semiconductor memory device.

(57) Parallel input data to be written into desired memory cells of a RAM (10) and supplied to an input terminal (16) is serially received by a plural-bit shift register (18) and stored therein. The data stored in the shift register (18) is transferred as write-in data to the RAM (10) via a transferring section (20) and written into memory cells of a desired address of the RAM (10). The data which has been written into the memory cells of the desired address is immediately read out and transferred as readout data to the shift register (18) via the transferring section (20) and held therein. The transferring section (20) includes a non-inverting type buffer section which is constituted by an inverter (22) and a clocked inverter (24) and arranged in a transferring path from the shift register (18) to the RAM (10) and an inverting type buffer section which is constituted by a clocked inverter (26) and arranged in a transferring path from the RAM (10) to the shift register (18). The readout data held in the shift register (18) is supplied to the determination section (32) and compared with the input data received by the input terminal (16).

FIG. 1

## Test circuit in semiconductor memory device

This invention relates to a test circuit formed in a semiconductor memory device, and more particularly to a test circuit for effecting a comparison determination by comparing write-in data with readout data in a semiconductor memory device in which data can be written and read out.

A semiconductor memory device having memory cells in which data can be written and read out is subjected to various operation tests before shipment from the factory or when a system such as a personal computer into which the semiconductor memory device is incorporated is first triggered. One of the operation tests is to effect a comparison determination by comparing write-in data with readout data.

The comparison determination is effected as follows. That is, data is written into memory cells with a desired address of a memory cell array via a device such as a shift register for serially storing parallel input data having a plurality of bits. Then, data is read out from the memory cells of the above desired address without writing data into memory cells of another address. The thus readout data is derived from an output terminal and compared with the input data which has been separately held so that the memory cells of the desired address can be tested.

In this case, data written into the memory cells and data read out from the memory cells are set in phase with each other in the logic level thereof, that is, they are set in the non-inverted relationship.

However, if the write-in data and the readout data are set in phase with each other in the logic level thereof, data written into the memory cells cannot be sufficiently tested for the following reason. That is, when data is written into memory cells of a desired address and the data is immediately read out from the memory cells of the desired address, it cannot be determined that data derived out from the output terminal is the write-in data or the readout data if the write-in data and readout data are set in phase with each other as described above since the data is read out via the shift register. This is because it is impossible to determine whether the data in the shift register is the write-in data or the readout data. For example, in a case where the shift register is disconnected from the memory cell, data in the shift register is not replaced by the readout data and thus the shift register continuously holds the write-in data, and as a result, the write-in data is output from the output terminal.

Therefore, the memory cells of the memory cell array cannot be tested with highly reliable result.

An object of this invention is to provide a test circuit which is incorporated in a semiconductor memory device and which can prevent write-in data from being output and properly test the memory cells in the memory cell array.

According to one aspect of this invention, there is provided a test circuit incorporated in a semiconductor memory device, comprising input means for receiving parallel input data to be written into desired memory cells of the memory cell array; storing means having plural-bit storage elements serially arranged, for sequentially storing the input data received by the input means into the storage elements and storing readout data read out from the memory cell array into the storage elements; transferring means arranged between the memory cell array and the storing means, for transferring data stored in the storing means to the memory cell array as write-in data to be written into the memory cell array and transferring the readout data from the memory cell array to the storing means, the transferring means including means for transferring the write-in data supplied from the storing means to the memory cell array and the readout data supplied from the memory cell array to the storing means as data having an inverted relationship; write-in/readout means for writing the write-in data transferred from the storing means by the transferring means into the desired memory cells of the memory cell array and reading out data written in the desired memory cells, and causing the transferring means to transfer the data thus read out to the storing means as the readout data; and determination means for receiving the input data received by the input means and the readout data stored in the storing means and comparing the received data with each other to determine whether the desired memory cells are normal or not.

This invention can be more fully understood from the following detailed description when taken in conjunction with the accompanying drawings, in which:

Fig. 1 is a diagram showing the circuit construction of a first embodiment of a test circuit in a semiconductor memory device according to this invention;

Fig. 2 is a timing chart for illustrating the operation of the test circuit shown in Fig. 1;

Figs. 3A and 3B are tables showing the states of a shift register in the test circuit of Fig. 1 at certain timings; and

Fig. 4 is a diagram showing the circuit construction of a second embodiment of a test circuit in a semiconductor memory device according to this invention.

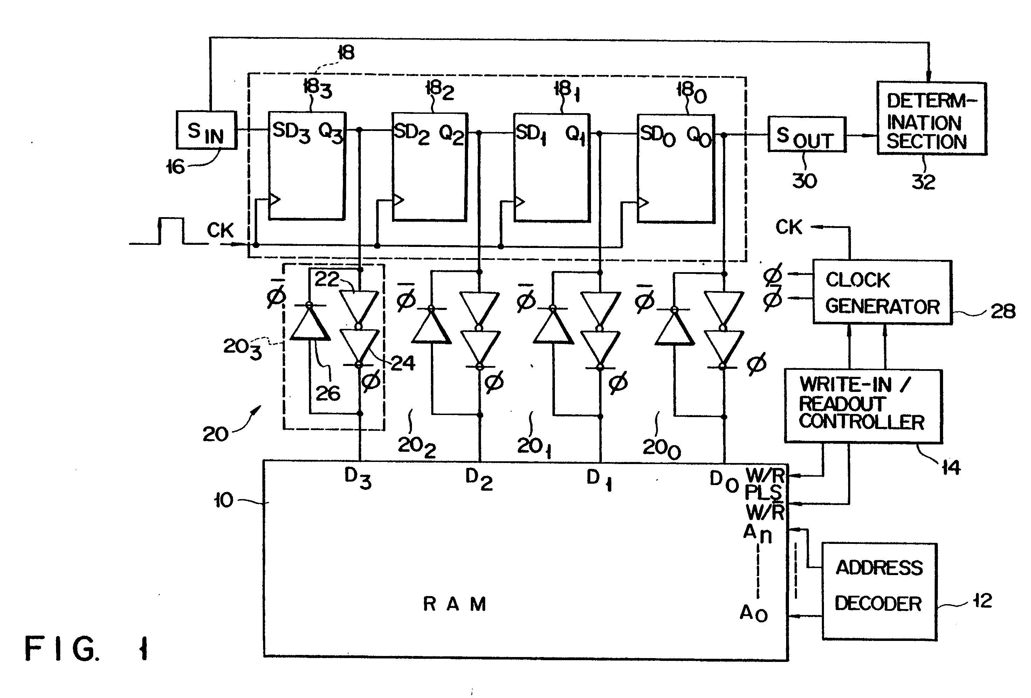

As shown in Fig. 1, a RAM 10 is a memory cell array in which plural-bit parallel data can be written into or read out from plural-bit memory cells of a desired address. Now, the embodiment in which 4-bit data is used as the plural-bit data is explained. However, this invention is not limited to the 4-bit data.

The RAM 10 is connected to an address decoder 12 and a write-in/readout controller 14. The address decoder 12 generates an address signal for designating a desired address of the RAM 10 and supplies the address signal to address terminals $A_n$ to $A_0$ when plural-bit parallel data is written into or read out from the RAM 10. The write-in/readout controller 14 generates a write-in/readout mode control signal W/ $\overline{M}$ for setting the RAM 10 into a write-in mode or readout mode and a write-in/readout pulse W/R PLS for permitting data to be written into the RAM 10 and supplies the above signals to a control terminal W/ $\overline{M}$ and W/R PLS of the RAM 10.

4-bit parallel input data supplied to an input terminal $(S_{IN})$ 16 is received in a serial fashion by a 4-bit shift register (SR) 18 constituted by 4-stage flip-flops $18_3$, $18_2$, $18_1$, and $18_0$. Q output terminals $(Q_3$ to $Q_0)$ of the flip-flops $18_3$, $18_2$, $18_1$, and $18_0$ of the shift register 18 are connected to data input terminals $D_3$ to $D_0$ of the RAM 10 via a transferring section 20 constituted by four bi-directional buffer circuits $20_3$, $20_2$, $20_1$, and $20_0$. That is, write-in data is supplied to the RAM 10 via the transferring section 20.

The bi-directional buffer circuits $20_3$, $20_2$, $20_1$, and $20_0$ are each constituted to have a non-inverting type buffer section formed of an inverter 22 and a clocked inverter 24 in the transferring path from the shift register 18 to the RAM 10 and an inverting type buffer section formed of a clocked inverter 26 in the transferring path from the RAM 10 to the shift register 18. The operation of the clocked inverter 24 of each of the bi-directional buffer circuits $20_3$, $20_2$, $20_1$, and $20_0$ is controlled by a control clock $\phi$, and the operation of the clocked inverter 26 of each of the bi-directional buffer circuits $20_3$, $20_2$, $20_1$, and $20_0$ is controlled by a control clock $\overline{\phi}$.

The control clocks $\phi$ and $\overline{\phi}$ are generated from a clock generator 28 in response to the write-in/readout mode control signal W/ $\overline{R}$ and write-in/readout pulse W/R PLS generated from the write-in/readout controller 14. The clock generator also generates a synchronizing clock CK for the shift register 18.

Readout data read out from the RAM 10 to the shift register 18 via the transferring section 20 is serially output from an output terminal $(S_{OUT})$ 30. Readout data from the output terminal 30 is supplied to a determination section 32. Also, the input data from the input terminal 16 is supplied to the determination section 32. Thus, the determination section 32 compares the input data supplied with the readout data and determine that the compared data are coincident or non-coincident so as to provide the result of test for the memory cell of the RAM 10 addressed.

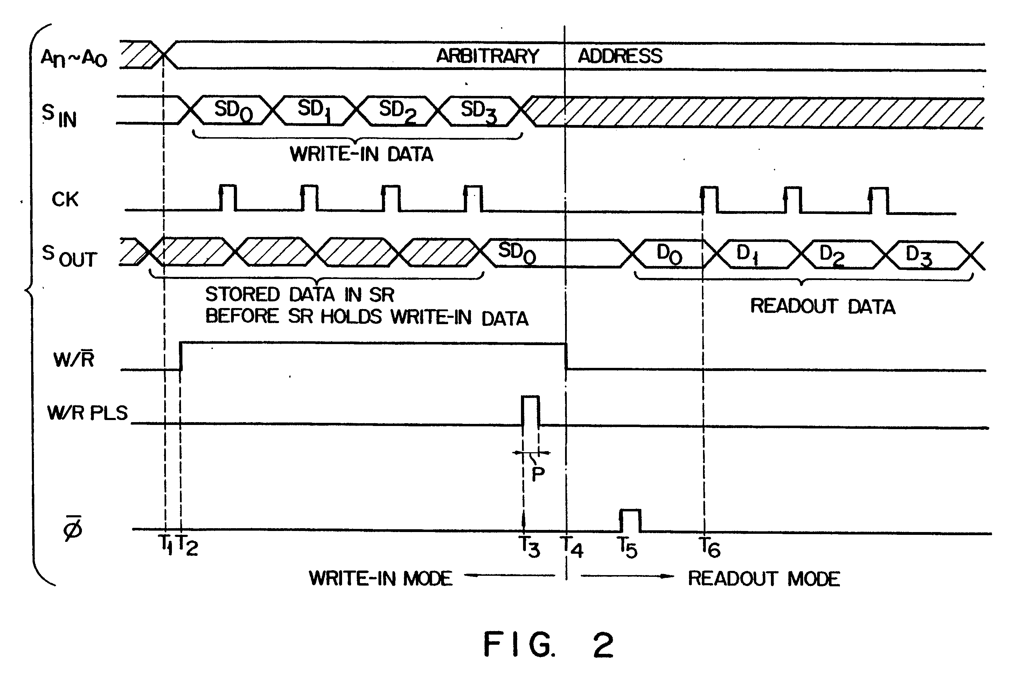

Now, the operation of the test circuit with the above construction is explained with reference to the timing chart shown in Fig. 2.

First, an address signal indicating a desired address of the RAM 10 is generated at the timing $T_1$ by the address decoder 12 and then supplied to the address terminals $A_n$ to $A_0$ of the RAM 10 to select a desired address of the RAM 10.

Next, the write-in/readout controller 14 sets the write in/readout mode control signal W/ $\overline{R}$ to a "high" level. As a result, the RAM 10 and clock generator 28 which receive the control signal W/ $\overline{R}$ are set into the write-in mode.

In the write-in mode, the clock generator 28 sequentially generates a synchronizing clock CK and supplies the same to the flip-flops $18_3$ to $18_0$ of the shift register 18. As a result, the shift register 18 serially receives the 4-bit parallel input data $(SD_3$ to $SD_0)$ from the input terminal 16 and holds the same. In this case, each synchronizing clock CK serves to shift data by one bit in the shift register 18.

The clock generator 28 further generates control clocks $\phi$ and $\overline{\phi}$. In the write-in mode, the control clock $\phi$ is set to a "1" level and the control clock $\overline{\phi}$ is set to a "0" level. Therefore, 4-bit parallel write-in data (in phase with the input data) output from the Q output terminals $Q_3$ to $Q_0$ of the shift register 18 is transferred to the RAM 10 via the non-inverting type buffer sections constituted by the inverters 22 and clocked inverters 24 of the bi-directional buffer circuits $20_3$ to $20_0$.

Next, the write-in/readout controller 14 supplies a write-in/readout pulse W/R PLS to the control terminal W/R PLS of the RAM 10 at the timing $T_3$. As a result, write-in data can be written into the memory cells of the RAM 10 having the address which has been already designated by the address decoder 12. The period P in which the write-in/readout pulse W/R PLS is set at the "high" level is used as a write-in period.

After the write-in operation, the write-in/readout controller 14 sets the write-in/readout mode control signal W/ $\overline{R}$ to the low level at the timing $T_4$. As a result, the RAM 10 and clock generator 28 which receive the write-in/readout mode control signal W/ $\overline{R}$ are set into the readout mode. At this time, the address is not changed.

Next, the clock generator 28 sets the control clocks $\phi$ and $\overline{\phi}$ to the "0" and "1" levels, respectively, at the timing $T_5$. Then, the non-inverting type buffer sections constituted by the inverters 22 and clocked inverters 24 of the bi-directional buffer circuits $20_3$ to $20_0$ are set to the OFF state, and the inverting type buffer sections constituted by the clocked inverters 26 of the bi-directional buffer circuits $20_3$ to $20_0$ are set to the ON state. As a result, the 4-bit parallel data written into the RAM 10 is transferred to the Q output terminals of the shift register 18 via the inverting type buffer sections and then held as the Q outputs. Therefore, at this time, readout data $D_0$ ($\overline{SD_0}$) is output from the output terminal 30 and supplied to the determination section 32.

After this, the clock generator 28 supplies a synchronizing clock CK to the shift register 18 at the timing $T_5$. Then, the flip-flops $18_2$ to $18_0$ of the shift register 18 store the readout data $D_3$ to $D_1$ ($\overline{SD_3}$ to $\overline{SD_1}$) which are stored as the Q outputs. The readout data is shifted in response to a synchronizing clock CK successively generated. In this way, the remaining readout data $D_3$ to $D_1$ are supplied from the output terminal 30 to the determination section 32.

The determination section 32 compares the input data (write-in data) $SD_3$ to $SD_0$ supplied from the input terminal 16 with the readout data $D_3$ to $D_0$ supplied from the output terminal 30. That is, the determination section 32 compares inverted data of the input data $SD_3$ to $SD_0$ used as expected values with the readout data $D_3$ to $D_0$, and determines that the memory cells at the address designated at this time are normal if the compared data are equal to each other.

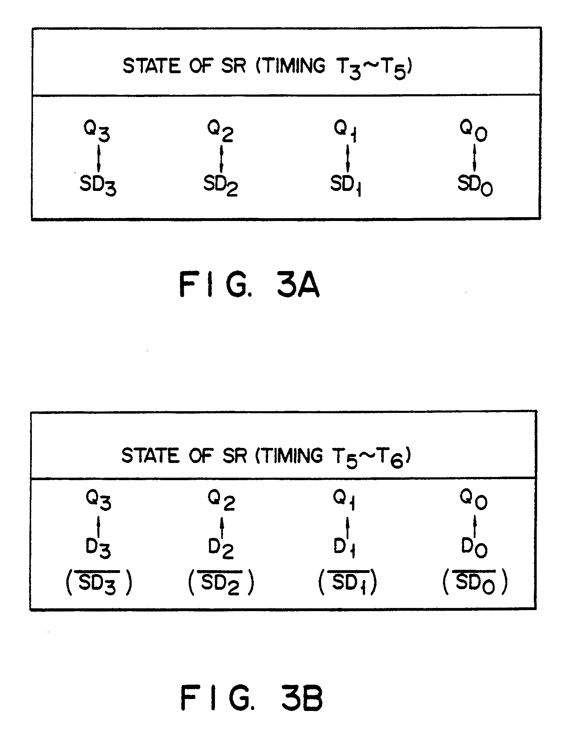

Fig. 3A shows the state of the shift register 18 in a period after the timing $T_3$ and immediately before the timing $T_5$. As is clearly seen from Fig. 3A, in this period, write-in data of the RAM 10 input from the input terminal 16 is stored in the shift register 18.

Fig. 3B shows the state of the shift register 18 in a period from the timing $T_5$ (at which data written into the RAM 10 is held in the shift register 18 via the inverting type buffer section constituted by a single stage of the clocked inverter 26) to the timing $T_6$ (which is immediately before readout data held in the shift register 18 is first shifted). As is clearly seen from Fig. 3B, in this period, data having an inverted logic level of that of the readout data from the RAM 10 is stored as the Q output of each flip-flop in the shift register 18.

In the test circuit of the first embodiment described above, if the write-in data "$Q_3Q_2Q_1Q_0 = 1010$" for the RAM 10 is stored in the state (in which write-in data for the RAM 10 is stored) of the shift register 18 set after the timing $T_3$ and before the timing $T_5$, for example, then data "$Q_3Q_2Q_0Q_0 = 0101$" is held in the state (in which readout data from the RAM 10 is stored) of the shift register 18 set in a period from the timing $T_5$ to the timing $T_6$. In this way, since data in the shift register 18 in the write-in mode has the same bit arrangement as and inverted logic levels of data in the shift register 18 in the readout mode, it is possible to correctly determine whether the shift register 18 holds the preceding write-in data or readout data newly read out.

The write-in/readout method includes a method of reading data from the memory cells of all the addresses after the data has been written into the memory cells of all the addresses and a method of writing data into memory cells of a specified address and then reading out the data from the memory cells of the specified address. In the above first embodiment, the latter method is used and therefore it is not necessary to change the address and a plurality of bits can be tested at the same time so that the test time can be shortened.

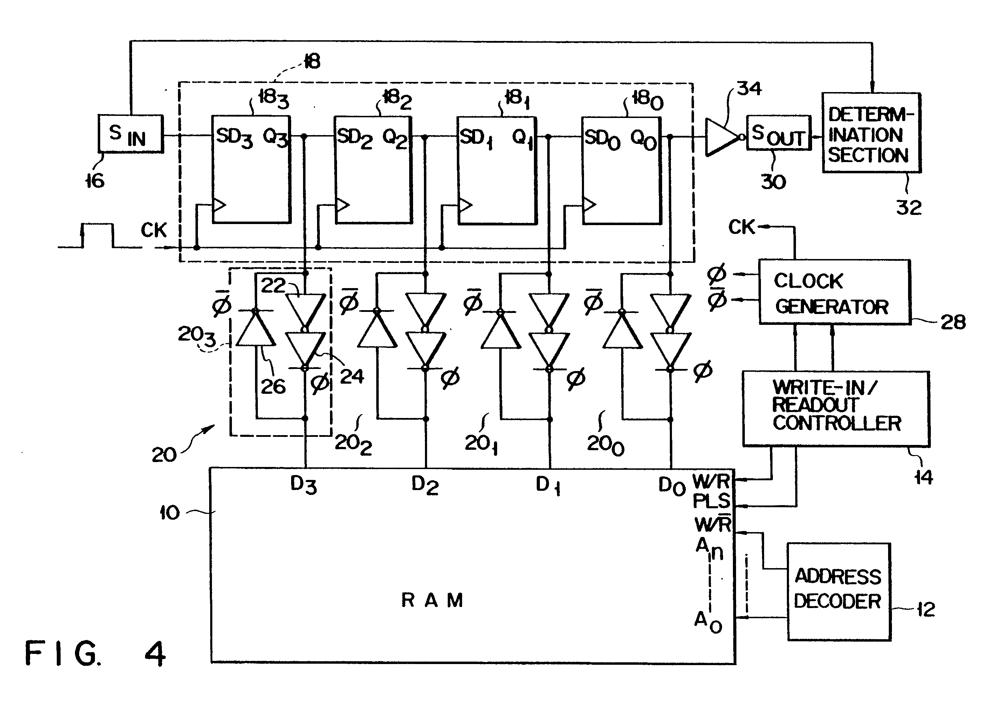

Fig. 4 is a diagram showing the circuit construction of the second embodiment of this invention. In the second embodiment, an inverter 34 is inserted between the shift register 18 and the output terminal 30 of Fig. 1. With this construction, data from the output terminal 30 can be directly compared with input data from the input terminal 16 by the determination section 32 while the phases thereof are kept in phase with each other.

As described above, according to this invention, when the data write-in/readout operation is effected for each memory cell of a desired address in the memory cell array, it is determined that data stored in the data storing section is cleared once at the data write-in time and readout data from the memory cells is newly set into the data storing section at the data readout time by use of the bi-directional buffer acting as the transferring section which is inserted between the shift register acting as the data storing section and the memory cell array and which is constructed to have one transferring path of non-inverting type and the other transferring path of inverting type, thereby making it possible to prevent erroneous readout due to breakage of the wiring between the data storing section and the memory cell array or the like. Further, since the write-in/readout operation is effected for each desired address, the operation of setting the address must be effected only once for each write-in/readout operation, thereby shortening the test time.

Reference signs in the claims are intended for better understanding and shall not limit the scope.

## Claims

1. A test circuit in a semiconductor memory device having a memory cell array, comprising:

input means (16) for receiving parallel input data to be written into desired memory cells of said memory cell array (10);

storing means (18) having plural-bit storage elements ($18_0$, $18_1$, $18_2$, $18_3$) serially arranged, for sequentially storing the input data received by said input means (16) into said storage elements ($18_0$, $18_1$, $18_2$, $18_3$) and storing readout data read out from said memory cell array (10) into said storage elements ($18_0$, $18_1$, $18_2$, $18_3$);

transferring means (20) arranged between said memory cell array (10) and said storing means (18), for transferring data stored in said storing means (18) to said memory cell array (10) as write-in data to be written into said memory cell array (10) and transferring the readout data from said memory cell array (10) to said storing means (18);

write-in/readout means (14) for writing the write-in data transferred from said storing means (18) by said transferring means (20) into said desired memory cells of said memory cell array (10) and reading out data written in said desired memory cells, and causing said transferring means (20) to transfer the data thus read out to said storing means (18) as the readout data; and

determination means (32) for receiving the input data received by said input means (16) and the readout data stored in said storing means (18) and comparing the received data with each other to determine whether said desired memory cells are normal or not, characterized in that

said transferring means (20) includes means ($20_0$, $20_1$, $20_2$, $20_3$) for transferring the write-in data supplied from said storing means (18) to said memory cell array (10) and the readout data supplied from said memory cell array (10) to said storing means (18) as data having an inverted relationship.

2. The test circuit according to claim 1, characterized by further comprising inverting means (34) connected between said storing means (18) and said determination means (32), for inverting the logic level of readout data stored in said storing means (18) and then transferring the inverted readout data to said determination means (32).

3. The test circuit according to claim 1 or 2, characterized in that said transferring means (20) includes:

non-inverting type transferring means for transferring the write-in data from said storing means (18) to said memory cell array (10) without inverting the same; and

inverting type transferring means for inverting the logic level of the readout data from said memory cell array (10) and then transferring the inverted readout data to said storing means (18).

4. The test circuit according to claim 3, characterized in that said non-inverting type transferring means includes an inverter (22) and a first clocked inverter (24) and said inverting type transferring means includes a second clocked inverter (26).

5. The test circuit according to claim 4, characterized by further comprising clock generating means (28) for generating clock signals ($\phi$, $\bar{\phi}$) for operating said first and second clocked inverters (24, 26) in a complementary fashion.

6. The test circuit according to claim 5, characterized in that said write-in/readout means (14) includes means for reading data from the desired memory cells after the data has been written into the desired memory cells and inhibiting data write-in operation with respect to memory cells other than the desired memory cells in a period from the data write-in into the desired memory cells to the data readout from the desired memory cells; and said clock generating means (28) includes means for generating a first clock signal ($\phi$) for operating said first clocked inverter (24) when said write-in/readout means (14) writes data into the desired memory cells and a second clock signal ($\bar{\phi}$) for operating said second clocked inverter (26) when said write-in/readout means (14) reads out data from the desired memory cells.

F I G. 1

EP 0 398 357 A2

FIG. 2

EP 0 398 357 A2

| STATE OF SR (TIMING $T_3 \sim T_5$) | | | |
|:---:|:---:|:---:|:---:|
| $Q_3$ | $Q_2$ | $Q_1$ | $Q_0$ |
| $\downarrow$ | $\downarrow$ | $\downarrow$ | $\downarrow$ |
| $SD_3$ | $SD_2$ | $SD_1$ | $SD_0$ |

FIG. 3A

| STATE OF SR (TIMING $T_5 \sim T_6$) | | | |
|:---:|:---:|:---:|:---:|
| $Q_3$ | $Q_2$ | $Q_1$ | $Q_0$ |
| $\downarrow$ | $\downarrow$ | $\downarrow$ | $\downarrow$ |
| $D_3$ | $D_2$ | $D_1$ | $D_0$ |
| $(\overline{SD_3})$ | $(\overline{SD_2})$ | $(\overline{SD_1})$ | $(\overline{SD_0})$ |

FIG. 3B

F I G. 4

EP 0 398 357 A2